# EUROPÄISCHE PATENTSCHRIFT

(11) **EP 3 435 097 B1**
(45) Veröffentlichungstag und Bekanntmachung des Hinweises auf die Patenterteilung: **11.09.2024**
(21) Anmeldenummer: 17075013.7
(22) Anmeldetag: 26.07.2017
(51) Int. Cl.: G01R 15/18

(54) **STROMERFASSUNGSSYSTEM**
SYSTEM FOR CURRENT DETECTION
SYSTÈME DE DÉTECTION DE COURANT

(43) Veröffentlichungstag der Anmeldung: 30.01.2019
(73) Patentinhaber: Enertex Bayern GmbH, 91301 Forchheim (DE)
(72) Erfinder: Schuster, Michael, 91301 Forchheim (DE)

(56) Entgegenhaltungen:
- EP-A1- 1 923 709
- EP-A1- 2 742 887

## Beschreibung

Die Erfindung betrifft ein Stromerfassungssystem zum Messen von Wechselströmen in Anlagen der elektrischen Energieversorgung. Diese Anlagen werden in der Fachliteratur auch Schaltanlagen genannt. Das Stromerfassungssystem dient zur Erfassung von Strömen in Schaltanlagen und deren Wandlung in Kleinsignale zur Auswertung in Schutzeinrichtungen, zur Auswertung in Leitsystemen, sowie zur Auswertung der aktuellen Betriebsströme für Lastgänge, für Systeme zur Lastflussregelung und Diagnosevorrichtungen.

Zum Messen der Ströme in der Schaltanlage ist der Stand der Technik die Verwendung von Stromwandlern 1]. Ein Stromwandler ist ein Messwandler, der einen hohen Primärstrom in ein gut verarbeitbares elektrisches Signal überträgt. Im engeren Sinne wird darunter ein auf messtechnische Erfordernisse ausgelegter Transformator mit Eisenkern verstanden, der zum potentialfreien Messen großer Wechselströme dient. Diese Art des Stromwandlers gibt als Ausgangssignal einen Sekundärstrom von Milliampere bis wenigen Ampere ab, der im Wesentlichen proportional zum Primärstrom ist. Dabei weicht der Sekundärstrom bei einem Stromwandler gegenüber dem Primärstrom um einen Phasenverschiebungswinkel ab, der bei passendem Anschluss annähernd null ist. Der mit der Wandlung verbundene Magnetisierungsstrom ist neben der Kernsättigung eine weitere Ursache von Messabweichungen. Das Stromsignal als Ausgangsstrom des Stromwandlers ist eine Stromquelle, deren Linearität bezüglich der Wandlung des primärseitigen Stromes in ein dazu möglichst proportionales Kleinsignal zusätzlich von der auf der Sekundärseite des Stromwandlers angeschlossen ohmschen Last, in der Fachliteratur 2] Bürde genannt, abhängig ist.

Das verwendete Eisenmaterial für den Kern des Stromwandlers, sowie die Übersetzungsverhältnisse und die Bürde beeinflussen demnach die Qualität der Messung, wobei unter guter Qualität ein möglichst über einen weiten Bereich des Primärstromes proportionales Kleinsignal zu verstehen ist. Daher werden für Schutzeinrichtungen, Leitsysteme, Lastflussregelung und Diagnosevorrichtungen unterschiedliche Stromwandler in einer Schaltanlage verbaut, weil die verschiedenen Auswerteeinrichtungen unterschiedliche Anforderungen bezüglich der Genauigkeit des maximal und minimal zu messenden Wechselstroms aufweisen.

Stromwandler besitzen je nach Anwendung unterschiedliche Kennlinien:
- für Messzwecke, zur Erzeugung eines innerhalb des Messbereiches möglichst proportional herabgesetzten Stromes für Strommessgeräte, Energiezähler. Solche Wandler schützen sich und die angeschlossenen Messgeräte bei Überstrom, indem sie in die Sättigung gehen.
- für Schutzzwecke, zur Übertragung eines herabgesetzten Stromes an Schutzrelais, Steuer- und Regelgeräte. Solche Wandler liefern auch bei hohen Überströmen noch ein primärstromabhängiges Ausgangssignal.

Bei dem einer Anlage muss daher für jeden Einsatz ein jeweils für jeden Anwendungszweck (Messung oder Schutz) ein einzelner Stromwandler vorgesehen werden.

Anstelle des Stromwandlers kann eine Rogowski-Spule verwendet werden. Diese benötigt einen Rogowski-Integrator (3],4],5]). Sie erzeugt ein dem Wechselstrom, der in einem von der Rogovksi-Spule umschlossenen Leiter fließt, proportionales Ausgangssignal. Da die Rogowski-Spule keinen Eisenkern und vernachlässigbare Verluste aufweist, gibt es so gut wie keine Einschränkung des Messbereichs. Ein Nachteil dieses Messsensors ist jedoch, dass das Ausgangssignal proportional mit der ersten Ableitung des Stromes nach der Zeit ist und daher integriert werden muss. Dies war ein Problem bei den früheren analogen Integratoren 6]. Stand der Technik ist, dieses Problem mit Hilfe der numerischen Integration in Form der digitalen Signalverarbeitung zu lösen 7], wobei in Schaltanlagen nur der Frequenzbereich zwischen 25 und meist 500 Hz, seltener bis 3000 Hz interessiert. Daher reicht in diesen Fällen ein einfacher Bandpass, um die Anforderungen an die Genauigkeit zu erfüllen. 8] schlägt vor, den Integrator durch Auswertung der nicht integrierten Rogowskispannung vor Überlauf zu schützen. Anordnungen von Stromsensoren in der Ausführung als Rogowski-Einheiten zur Messung von Wechselströmen sind bekannt 9].

Trotz der Vorteile hat der Rogowski-Sensor den oben erwähnten Stromwandler nicht in der Anlagen der elektrischen Energieversorgung abgelöst, zumal diese kostengünstiger zu bauen sind. In 10] wird der Sensor direkt in einen Leistungsschalter der Schaltanlage integriert, um eine Schutzeinrichtung von anderen Stromsensoren unabhängig zu machen.

Der Erfindung liegt die Aufgabe zugrunde, ein Stromerfassungssystem und ein Verfahren anzugeben, welches ausgebildet ist, das Messen von Wechselströmen mit mehrfachen Ausgangssignalen für unterschiedliche Messbereiche bei Verwendung von nur einem Sensor in Anlagen der elektrischen Energieversorgung durchzuführen.

Zum Stand der Technik sind Rogowski Einheiten mit gesonderten Aufbau bekannt: [11] zeigt einen Aufbau für Rogowski Spulen, der für Ströme von wenigen mA bis einigen hundert Ampere geeignet ist. Um dies zu erreichen, wird von der üblichen Bauweise der Rogowskispulen [6], wie in der Patentschrift [11] angegeben, abgewichen. Ziel dieser Variante ist, u. a. die Verbesserung der Empfindlichkeit bzw. der Vereinfachung des Aufbaus bei gleichzeitiger Senkung der Herstellungskosten. [12] stellt eine weitere Variante dieses Messprinzips dar, wobei hier der Aufbau auf die Messung von Hochfrequenzen (RF) optimiert ist. Die beiden genannten Erfindungen zielen damit auf einen anderen Frequenzbereich, fokussieren sich auf den eigentlichen Sensor. Das hier vorgestellte Stromerfassungssystem hingegen zielt auf ein Vervielfachen eines Sensorsignals für die Ströme im Energieversorgungsnetz im Frequenzbereich 50 bis 3.000 Hz, wobei die Form des Ausgangssignals in der gleichen Form wie für konventionelle Stromwandler vorliegt, das Ausgangssignal in einem bestimmten Bereich skaliert und optional mehrfach in unterschiedlicher Skalierung als Strom oder Spannungssignal ausgegeben werden kann.

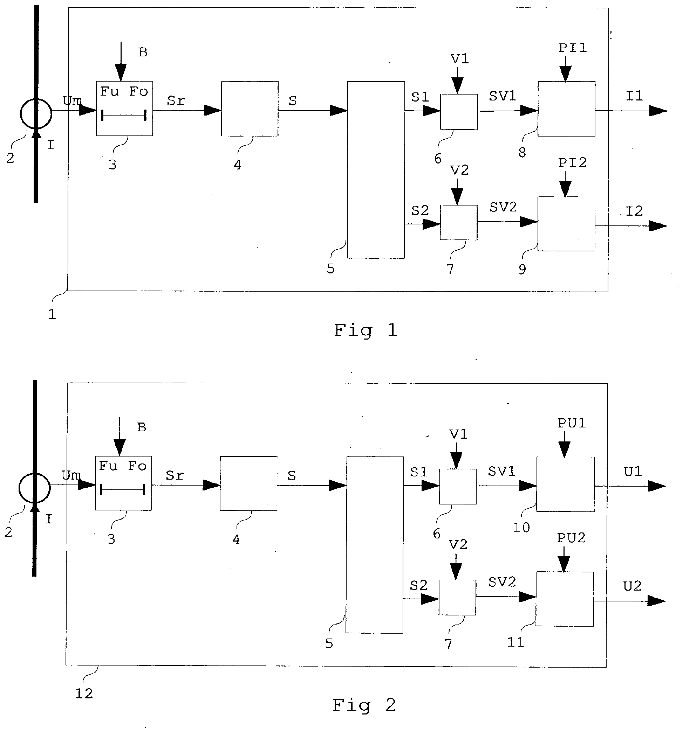

Diese Aufgabe wird gelöst durch ein Stromerfassungssystem zum Messen von Wechselströmen mit mehrfachen Ausgangssignalen bei Verwendung von nur einem Sensor, aufweisend wie Fig 1 eine externe Rogowski-Spule (2), die ausgangsseitig ein Spannungssignal ausgibt, welches die Induktionsspannung Um zum Wechselstrom I, der in einem Leiter der Anlage fließt, darstellt, dadurch gekennzeichnet, dass Um die proportionale, mathematisch erste Ableitung des Stromes I darstellt,
∘ eine Umwandlereinheit (3), die ausgebildet ist, das analoge Spannungssignal Um in ein digitales Signal Sr umzuwandeln, dadurch gekennzeichnet, dass aus dem Signal Sr ein Frequenzbereich mit der unteren Frequenzgrenze Fu und der oberen Frequenzgrenze Fo gefiltert wird, dadurch gekennzeichnet, dass das Signal mit dem einstellbaren linearen Verstärkungsfaktor B skaliert wird,
∘ einen Rogowski-Integrator (4), der ausgebildet ist, das Signal Sr zu integrieren, dessen Ausgangssignal S die Integration der Spannung Um darstellt, dadurch gekennzeichnet, dass Sr proportional zu I ist,
∘ eine Vervielfältigungseinheit (5), welche ausgebildet ist, das Signal S in gleiche Signale S1 und S2 zu vervielfältigen, dadurch gekennzeichnet, dass n eine beliebige positive Zahl größer Null ist,
∘ eine erste Skalierungseinheit (6), die ausgebildet ist, das Signal S1 mit einem Verstärkungsfaktor V1 zu multiplizieren, dadurch gekennzeichnet, dass sie Ausgangssignal SV1 proportional zu S1 ausbildet und zudem der Proportionalitätsfaktor sich mit der Änderung von V1 proportional verändert,
∘ eine zweite Skalierungseinheit (7), die ausgebildet ist, das Signal S2 mit einem Verstärkungsfaktor V2 zu multiplizieren, dadurch gekennzeichnet, dass sie Ausgangssignal SV2 proportional zu S2 ausbildet und zudem der Proportionalitätsfaktor sich mit der Änderung von V2 proportional verändert,
∘ eine erste Wandlungseinheit (8), die ausgebildet ist, das Signal SV1 in einen proportionalen Strom I1 umzuwandeln, dadurch gekennzeichnet, dass diese ausgebildet ist, dass der Strom I1 bis zu einer vorgebbaren maximalen Leistungsabgabe PI1 in die Ausgangsseite eingeprägt wird,
∘ eine zweite Wandlungseinheit (9), die ausgebildet ist, das Signal SV2 in einen proportionalen Strom I2 umzuwandeln, dadurch gekennzeichnet, dass diese ausgebildet ist, dass der Strom I2 bis zu einer vorgebbaren maximalen Leistungsabgabe PI2 in die Ausgangsseite eingeprägt wird.

Ein entsprechendes Verfahren ist im Anspruch 8 definiert.

Im folgenden werden Ausführungsbeispiele der Erfindung beschrieben, die anhand von Figuren erläutert werden.
**Fig 1**
   Stromerfassungssystem für einen Stromsensor und zwei Stromausgangssignale
**Fig 2**
   Stromerfassungssystem für einen Stromsensor und zwei Spannungsausgangssignale
**Fig 3**
   Stromerfassungssystem für einen Stromsensor und zwei digitalen Ausgangssignale
**Fig 4**
   Stromerfassungssystem für einen Stromsensor und drei Stromausgangssignale
**Fig 5**
   Stromerfassungsmatrix für drei verschiedene Stromsensoren und drei Ausgabeeinheiten

Im Rahmen einer ersten vorteilhaften Ausbildung nach **Fig 2** ist die erste Wandlungseinheit (10) in der Lage, das Ausgangssignal SV1 der ersten Skalierungseinheit in eine proportionale Wechselspannung U1 umzuwandeln und diese Wechselspnnung U1 bis zu einer vorgebbaren, maximalen Leistungsabgabe (PU1) in die Ausgangsseite einzuprägen, dadurch gekennzeichnet, dass die zweite Wandlungseinheit (11) ausgebildet ist, das Ausgangssignal SV2 der zweiten Skalierungseinheit in eine proportionale Wechselspannung U2 umzuwandeln und die Wechselspannung U2 bis zu einer vorgebbaren maximalen Leistungsabgabe PU2 in die Ausgangsseite eingeprägt wird.

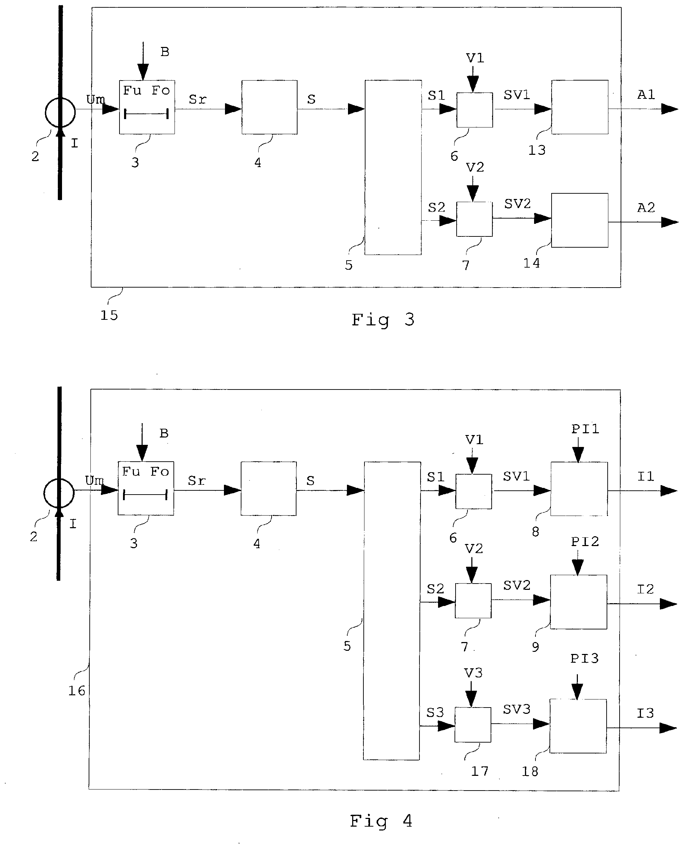

Im Rahmen einer weiteren vorteilhaften Ausbildung nach **Fig 3** ist die erste Wandlungseinheit (13) ausgebildet, das Ausgangssignal SV1 der ersten Skalierungseinheit in über ein Protokoll nach dem Stand der Technik (z.B. TCP, UDP) als digitales Signal A1 zur Verfügung zu stellen, die zweite Wandlungseinheit (14) ist ausgebildet, das Ausgangssignal SV2 der zweiten Skalierungseinheit über ein Protokoll nach dem Stand der Technik (z.B. TCP, UDP) als digitales Signal A2 zur Verfügung zu stellen.

In Rahmen von einer vorteilhaften Ausprägung nach **Fig 4** bildet erfindungsgemäß die Vervielfältugungseinheit ein weiteres Ausgangssignal S3 aus, welches über eine dritte Wandlungseinheit (17) und eine dritte Skalierungsheit mit Verstärkung V3 am Ende als drittes Stromsignal 13 mit maximaler Leistungsabgabe PI3 ausgegeben wird.

In Rahmen von vorteilhaften Ausprägungen werden die Anzahl der Ausgabeeinheiten und deren Ausgabe als Stromquelle (**Fig 1**) oder Spannungsquellen (**Fig 2**) oder digitale Signale (**Fig 3**) beliebig in der Anzahl kombiniert.

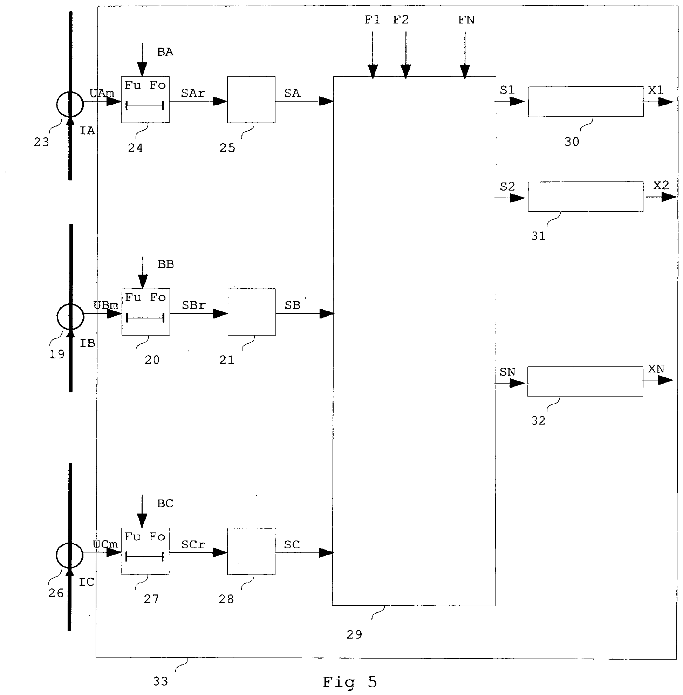

Die erfindungsgemäße Stromerfassungsmatrix (30) ist nach **Fig 5** dargestellt. Diese verarbeitet drei Wechselströme IA, IB, IC und führt diese auf erfindungsgemäße Umwandlereinheiten (24,20,27) und Rogovski-Integratoren (25,21,28). Die Stromerfassungsmatrix ist mit einer Berechnungmatrix (29) ausbildet, die die drei Ausgangssignale der Rogovski-Integratoren als Eingangssignale aufweist, dadurch gekennzeichnet, dass die Vervielfältigungsmatrix für jeden der N Ausgänge, wobei beliebige N eine Zahl größer 2 darstellt, ein Konfigurationssignal (XN) aufweist, welches ausgebildet ist, entweder die arithmetische Summe SA+SB+SC der Ausgangssignale der drei Rogowski-Integratoren oder eines der drei Ausgangssignale SA, SB, SC der drei Rogowski-Integratoren an eine der N Ausgangseinheiten weiterzuleiten, wobei jede Ausgangseinheit sich aus einer erfindungsgemäßen Skalierungseinheit und einer Wandlungseinheit zusammensetzt. Die Summenbildung in der Stromerfassungsmatrix ermöglicht so die Berechnung des Nullstromes und die Ausgabe als Ausgangssignal, welches von Schutzeinrichtungen für den sog. empfindlichen Erdfehler 2] von Bedeutung ist.

Die erfindungsgemäße Stromerfassungsmatrix kann auf beliebige Anzahl von zu erfassenden unterschiedlichen Strömen erweitert werden, sodass z.B. die Vervielfältigungsmatrix konfiguriert wird, in Netzabschnitten einen Summenstrom oder einen Differenzstrom über einen Teil der gemessenen Ströme zu berechnen oder im beliebigen Mehrleitersystem Nullströme oder vektorielle Größen berechnet.

### Anlagen

[1] http://ritz-international.com/wp-content/uploads/2015/11/RITZ-Mittelspannungswandler_Standard_GER_2014_01.pdf
[2] Kiank, Fruth: Planungsleitfaden für Energieverteilungsanlagen, Publicis Publishing (15. Dezember 2010)
[3] Patent Offenlegungsschrift DE 199 59 789 A1
[4] Patent Veröffentlichungsnummer DE 10 2007 046 054 A1
[5] Patent Veröffentlichungsnummer US 9588147 B2
[6] High Performance Rogowski Current Transducers, W. F. Ray and C. R. Hewson, Power Electronic Measurements Ltd., 25 Barratt Lane, Attenborough, Nottingham NG9 6AD, U.K.
[7] Patent Veröffentlichungsnummer EP 2 653 876 A1
[8] Patent Veröffentlichungsnummer DE 102012107021 A1
[9] http://ritz-international.com/wp-content/uploads/2015/12/RITZ-Elektronische_Messwandler_und_Sensoren_GER_2013-02.pdf
[10] Patent Veröffentlichungsnummer DE 198 25 383 B4
[11] Patent Veröffentlichungsnummer EP 1 923 709 A1
[12] Patent Veröffentlichungsnummer EP 2 742 887 A1

## Patentansprüche

1. Stromerfassungssystem (1) zum Messen von Wechselströmen mit mehrfachen Ausgangssignalen bei Verwendung von nur einem Sensor in Anlagen der elektrischen Energieversorgung aufweisend
∘ eine externe Rogowski-Spule (2), die ausgangsseitig ein Spannungssignal (Um) ausgibt, welches die Induktionsspannung zum Wechselstrom (I), der in einem Leiter durch die Rogowski-Spule der Anlage fließt, darstellt, wobei das Spannungssignal (Um) die proportionale, mathematisch erste Ableitung des Wechselstromes (I) darstellt,
∘ eine Umwandlereinheit (3), die ausgebildet ist, das analoge Spannungssignal (Um) in ein digitales Signal (Sr) umzuwandeln, im folgenden Signal bezeichnet, wobei aus dem Signal (Sr) ein Frequenzbereich mit der unteren Frequenzgrenze (Fu) und der oberen Frequenzgrenze (Fo) gefiltert wird, wobei das Signal mit einem einstellbaren linearen Verstärkungsfaktor (B) skaliert wird,
∘ einen Rogowski-Integrator (4), der ausgebildet ist, das Signal (Sr) zu integrieren, dessen Ausgangssignal (S) die Integration der Spannung (Um) darstellt, wobei das Ausgangssignal des Integrators (Sr) proportional zum Wechselstrom (I) ist,
∘ eine Vervielfältigungseinheit (5), welche ausgebildet ist, das Ausgangssignal des Integrators, (S) in zwei gleiche Signale (S1) und (S2) zu vervielfältigen,
∘ eine erste Skalierungseinheit (6), die ausgebildet ist, das erste Ausgangssignal der Vervielfältigungseinheit (S1) mit einem Verstärkungsfaktor (V1) zu multiplizieren, wobei sie das Ausgangssignal (SV1) proportional zum ersten Ausgangssignal der Vervielfältigungseinheit (S1) ausbildet und zudem der Proportionalitätsfaktor sich mit der Änderung des Verstärkungsfaktors (V1) proportional verändert,
o eine zweite Skalierungseinheit (7), die ausgebildet ist, das zweite Ausgangssignal der Vervielfältigungseinheit (S2) mit einem Verstärkungsfaktor (V2) zu multiplizieren, wobei sie das Ausgangssignal (SV2) proportional zum zweiten Ausgangssignal der Vervielfältigungseinheit (S2) ausbildet und zudem der Proportionalitätsfaktor sich mit der Änderung des Verstärkungsfaktor (V2) proportional verändert,
o eine erste Wandlungseinheit (8), die ausgebildet ist, das Ausgangssignal (SV1) der ersten Skalierungseinheit in einen proportionalen Wechselstrom (11) umzuwandeln, wobei diese ausgebildet ist, dass der Wechselstrom (11) bis zu einer vorgebbaren maximalen Leistungsabgabe (PI1) in die Ausgangsseite eingeprägt wird,
o eine zweite Wandlungseinheit (9), die ausgebildet ist, das Ausgangssignal (SV2) der zweiten Skalierungseinheit in einen proportionalen Wechselstrom (I2) umzuwandeln, wobei diese ausgebildet ist, dass der Wechselstrom (I2) bis zu einer vorgebbaren maximalen Leistungsabgabe (PI2) in die Ausgangsseite eingeprägt wird.

2. Stromerfassungsystem (12) nach Anspruch 1, **dadurch gekennzeichnet, dass** die erste Wandlungseinheit (10) ausgebildet ist, das Ausgangssignal (SV1) der ersten Skalierungseinheit in eine proportionale Wechselspannung (U1) umzuwandeln und diese Wechselspnnung (U1) bis zu einer vorgebbaren, maximalen Leistungsabgabe (PU1) in die Ausgangsseite eingeprägt wird, **dadurch gekennzeichnet, dass** die zweite Wandlungseinheit (11) ausgebildet ist, das Ausgangssignal (SV2) der zweiten Skalierungseinheit in eine proportionale Wechselspannung (U2) umzuwandeln und die Wechselspannung (U2) bis zu einer vorgebbaren maximalen Leistungsabgabe (PU2) in die Ausgangsseite eingeprägt wird,

3. Stromerfassungsystem (15) nach Anspruch 1, wobei die erste Wandlungseinheit (13) ausgebildet ist, das Ausgangssignal (SV1) der ersten Skalierungseinheit über ein Protokoll nach dem Stand der Technik (z.B. TCP, UDP) als erstes digitales Signal (A1) zur Verfügung zu stellen, wobei zweite Wandlungseinheit (14) ausgebildet ist, das Ausgangssignal (SV2) der zweiten Skalierungseinheit über ein Protokoll nach dem Stand der Technik (z.B. TCP, UDP) als zweites digitales Signal (A2) zur Verfügung zu stellen.

4. Stromerfassungssystem nach einem der vorhergehenden Ansprüche, **dadurch gekennzeichnet, dass** die Werte der maximalen Leistungsabgabe der Skalierungseinheiten, Verstärkungsfaktoren der Vervielfältigungseinheiten, die unteren und oberen Frequenzgrenzen und linearen Verstärkungsfaktoren der Umwandlereinheiten teilweise oder sämtlich fest hinterlegt sind.

5. Stromerfassungssystem nach einem der vorhergehenden Ansprüche, **dadurch gekennzeichnet, dass** die Vervielfältigungseinheit (4) mindestens ein weiteres Ausgangssignal aufweist, welches das Eingangssignal einer weiteren Skalierungseinheit darstellt, wobei jede weitere Skalierungseinheit ausgebildet ist, jedes weitere Ausgangssignal der Vervielfältigungseinheit mit jeweils einem weiteren einstellbaren Verstärkungsfaktor zu skalieren und dann jeweils einer weiteren Wandlungseinheit zuzuführen, **dadurch gekennzeichnet, dass** jede jeweils weitere Wandlungseinheit mit weiteren einstellbaren maximalen Leistungsabgaben der jeweiligen Ausgangsströme oder Ausgangsspannungen die Eingangsgrößen verarbeitet und als weiteres Ausgangssignal zur Verfügung stellt.

6. Stromerfassungsmatrix (33) bestehend aus drei Stromerfassungssystemen nach einem der vorhergehenden Ansprüche, wobei ein erster Wechselstrom (IA) gemessen wird, indem die Ausgangsspannung (UAm) der ersten Rogowski-Spule (23) der ersten Umwandlereinheit mit dem ersten Verstärkungsfaktor (BA) und dem ersten Rogowski-Integrator (25) zugeführt wird und dessen erste Ausgangsgröße (SA) einer Vervielfältigungsmatrix (29) als Eingangsgröße zugeführt wird, wobei der zweite Wechselstrom IB gemessen wird, indem die Ausgangsspannung (UBm) der zweiten Rogowski-Spule (20) der zweiten Umwandlereinheit und deren Ausgangssignal dem zweiten Rogowski-Integrator (21) zugeführt wird und als Ausgangsgröße (SB) der Vervielfältigungsmatrix (29) als Eingangsgröße zugeführt wird, **dadurch gekennzeichnet, dass** der dritte Wechselstrom IC gemessen wird, indem die Ausgangsspannung (UCm) der dritten Rogowski-Spule (26) der dritten Umwandlereinheit (27) und deren Ausgangssignal dem dritten Rogowski-Integrator (28) zugeführt wird und als Ausgangsgröße (SC) der Vervielfältigungsmatrix (29) als Eingangsgröße zugeführt wird, **dadurch gekennzeichnet, dass** die Vervielfältigungsmatrix einen der Eingänge (SA), (SB),(SC) auf einen ihrer beliebig vielen Ausgänge (S1, S2,... SN), (Anzahl N) ausgibt, dass die Vervielfältigungsmatrix ein Konfigurationssignal (F1, F2, ... FN) für jeden Ausgang aufweist, welches festlegt, welcher der Eingänge auf welchem Ausgang ausgegeben wird, dass das Konfigurationssignal (F1, F2, ... FN) zudem festlegt, dass alternativ die Vervielfältigungsmatrix die arithmetische Summe der Ausgangssignale der drei Rogowski-Integratoren (SA),(SB),(SC) ermittelt, und diese an einen oder mehreren der N Ausgänge (S1, S2,... SN) weiterleitet, **dadurch gekennzeichnet, dass** die Ausgänge (S1, S2,... SN) der Vervielfältigungsmatrix ebenso vielen Ausgangseinheiten (30,31,32) weitergeleitet werden, wobei jede Ausgangseinheit sich aus einer Skalierungseinheit und einer Wandlungseinheit aus einem der vorangegangen Ansprüchen zusammensetzt und das Ausgangssignal (X1, X2, ... XN) ausbildet.

7. Stromerfassungsmatrix nach Anspruch 6, bestehend aus beliebig vielen Stromerfassungssystemen, wobei die Vervielfältigungsmatrix weitere Strompfade durch Berechnungen arithmetisch oder vektoriell addiert und an eine der Ausgangseinheiten ausgibt, **dadurch gekennzeichnet, dass** die Vervielfältigungsmatrix Ströme von beliebigen Mehrphasensysteme oder Teilnetzen verarbeitet.

8. Verfahren zum Messen von Strömen mit mehrfachen Ausgangssignalen bei Verwendung von nur einem Sensor in Anlagen der elektrischen Energieversorgung mit folgenden Verfahrensschritten:
∘ Umwandlung eines empfangenen analogen Spannungssignals einer Rogowski-Spule in ein digitales Signal, im folgenden als Signal bezeichnet, wobei aus dem Signal ein Frequenzbereich mit der unteren Frequenzgrenze und der oberen Frequenzgrenze gefiltert wird, **dadurch gekennzeichnet, dass** das Signal mit einem einstellbaren linearen Verstärkungsfaktor skaliert wird,
∘ Integration des Signals durch einen Rogowski-Integrator, wobei dieser Rogowski-Integrator ausgebildet ist, die Anpassung des übertragenen Frequenzbereichs und Verstärkung des Spannungssignals vorzunehmen, wobei das Ausgangssignal des Rogowski-Integrators dem Wechselstrom in einem Leiter, welchen die Rogowski-Spule umschließt, proportional ist, wobei das integrierte Spannungssignal zu dem zu messenden Wechselstrom proportional ist,
∘ Vervielfältigung des Ausgangssignals in zwei gleiche Signale,
∘ Skalierung des ersten Ausgangssignals der Vervielfältigungseinheit mit einem ersten Verstärkungsfaktor, wobei das erste skalierte Ausgangssignal proportional zum ersten Ausgangssignal der Vervielfältigungseinheit ausgebildet ist und der erste Proportionalitätsfaktor sich mit der Änderung des Verstärkungsfaktors proportional verändert,
∘ Skalierung des zweiten Ausgangssignals der Vervielfältigungseinheit mit einem zweiten Verstärkungsfaktor, wobei das zweite skalierte Ausgangssignal proportional zum zweiten Ausgangssignal der Vervielfältigungseinheit ausgebildet ist und der zweite Proportionalitätsfaktor sich mit der Änderung des Verstärkungsfaktors proportional verändert,
∘ Wandlung des skalierten ersten Ausgangssignal in einen proportionalen Wechselstrom, wobei der Wechselstrom bis zu einer vorgebbaren ersten maximalen Leistungsabgabe in die Ausgangsseite eingeprägt wird,
∘ Wandlung des skalierten zweiten Ausgangssignals in einen proportionalen Wechselstrom, wobei der Wechselstrom bis zu einer vorgebbaren zweiten maximalen Leistungsabgabe in die Ausgangsseite eingeprägt wird,

9. Verfahren nach Anspruch 8 **dadurch gekennzeichnet, dass** die Ausgangssignale als Spannungssignale zur Verfügung stehen,

10. Verfahren nach Ansprüche 8 **dadurch gekennzeichnet, dass** die Ausgangssignale als digitale Signale zur Verfügung stehen,

11. Verfahren nach Anspruch 10, wobei Spannungssignale von mehreren Rogowski-Spulen als Messsignal von verschiedenen Wechselströmen verschiedenen Rogowski-Integratoren zugeführt werden, wobei die verschiedenen Ausgangssignale der Rogowski-Integratoren konfigurierbar als deren arithmetische oder vektorielle Summe oder als Einzelsignale an die Ausgabeeinheit ausgegeben werden.

## Claims

1. Current detection system (1) for measuring alternating currents with multiple output signals when using only one sensor in electrical power supply systems, comprising
∘ an external Rogowski coil (2), which emits a voltage signal (Um) on the output side, which represents the induction voltage to the alternating current (I), which flows in a conductor through the Rogowski coil of the system, whereby the voltage signal (Um) represents the proportional, mathematical first derivative of the alternating current (I),
∘ a converter unit (3) which is designed to convert the analogue voltage signal (Um) into a digital signal (Sr), hereinafter referred to as signal,wherein a frequency range with the lower frequency limit (Fu) and the upper frequency limit (Fo) is filtered from the signal (Sr), wherein the signal is scaled with an adjustable linear amplification factor (B),
∘ a Rogowski integrator (4) which is designed to integrate the signal (Sr), the output signal (S) of which represents the integration of the voltage (Um), the output signal of the integrator (Sr) being proportional to the alternating current (I),
∘ a multiplication unit (5) which is designed to multiply the output signal of the integrator (S) into two equal signals (S1) and (S2),
∘ a first scaling unit (6) which is designed to multiply the first output signal of the multiplication unit (S1) by an amplification factor (V1), the output signal (SV1) being proportional to the first output signal of the multiplication unit (S1) and the proportionality factor also changing proportionally with the change in the amplification factor (V1),
∘ a second scaling unit (7) which is designed to multiply the second output signal of the multiplication unit (S2) by an amplification factor (V2), the output signal (SV2) being proportional to the second output signal of the multiplication unit (S2) and the proportionality factor also changing proportionally with the change in the amplification factor (V2),
∘ a first conversion unit (8) which is designed to convert the output signal (SV1) of the first scaling unit into a proportional alternating current (11), wherein this is designed so that the alternating current (I1) is impressed into the output side up to a predeterminable maximum power output (PI1),
∘ a second conversion unit (9), which is designed to convert the output signal (SV2) of the second scaling unit into a proportional alternating current (I2), wherein this is designed so that the alternating current (12) is impressed into the output side up to a pre - determinable maximum power output (PI2).

2. Current detection system (12) according to claim 1, **characterised in that** the first conversion unit (10) is designed to convert the output signal (SV1) of the first scaling unit into a proportional alternating voltage (U1) and this alternating voltage (U1) is impressed into the output side up to a predeterminable maximum power output (PU1), **characterised in that** the second conversion unit (11) is designed to convert the output signal (SV2) of the second scaling unit into a proportional alternating voltage (U2) and the alternating voltage (U2) is impressed into the output side up to a predeterminable maximum power output (PU2),

3. Current detection system (15) according to claim 1, wherein the first conversion unit (13) is designed to make the output signal (SV1) of the first scaling unit available as a first digital signal (A1) via a protocol according to the state of the art (e.g. TCP, UDP), wherein the second conversion unit (14) is designed to make the output signal (SV2) of the second scaling unit available as a second digital signal (A2) via a protocol according to the state of the art (e.g. TCP, UDP).

4. Current detection system according to one of the preceding claims, **characterised in that** the values of the maximum power output of the scaling units, amplification factors of the multiplication units, the lower and upper frequency limits and linear amplification factors of the converter units are partially or all permanently stored.

5. Current detection system according to one of the preceding claims, **characterised in that** the multiplication unit (4) has at least one further output signal which represents the input signal of a further scaling unit, each further scaling unit being designed to scale each further output signal of the multiplication unit with a further adjustable amplification factor and then to supply it to a further conversion unit in each case, scaling each further output signal of the multiplication unit with a further adjustable amplification factor in each case and then feeding it to a further conversion unit in each case, **characterised in that** each further conversion unit processes the input variables with further adjustable maximum power outputs of the respective output currents or output voltages and makes them available as a further output signal.

6. Current detection matrix (33) comprising three current detection systems according to one of the preceding claims, wherein a first alternating current (IA) is measured by supplying the output voltage (UAm) of the first Rogowski coil (23) of the first converter unit with the first amplification factor (BA) and the first Rogowski integrator (25) and its first output variable (SA) is supplied to a multiplication matrix (29) as input variable, wherein the second alternating current IB is measured, in that the output voltage (UBm) of the second Rogowski coil (20) of the second converter unit and its output signal is fed to the second Rogowski integrator (21) and is fed as output variable (SB) to the multiplication matrix (29) as input variable, **characterised in that** the third alternating current IC is measured, **in that** the output voltage (UCm) of the third Rogowski coil (26) of the third converter unit (27) and its output signal is fed to the third Rogowski integrator (28) and is fed as output variable (SC) to the multiplication matrix (29) as input variable, **characterised in that** the multiplication matrix assigns one of the inputs (SA), (SB), (SC) to one of its any number of outputs (S1, S2, .. SN), (number N), **in that** the duplication matrix has a configuration signal (F1, F2, ... FN) for each output, which determines which of the inputs is output on which output, **in that** the configuration signal (F1, F2, .... FN) also determines that, alternatively, the multiplication matrix determines the arithmetic sum of the output signals of the three Rogowski integrators (SA),(SB),(SC), and forwards these to one or more of the N outputs (S1, S2,.... SN), **characterised in that** the outputs (S1, S2, ... SN) of the multiplication matrix are forwarded to the same number of output units (30, 31, 32), each output unit being composed of a scaling unit and a conversion unit from one of the preceding claims and forming the output signal (X1, X2, ... XN).

7. Current detection matrix according to claim 6, consisting of any number of current detection systems, the multiplication matrix adding further current paths arithmetically or vectorially by calculations and outputting them to one of the output units, **characterised in that** the multiplication matrix processes currents from any multiphase systems or subnetworks.

8. Method for measuring currents with multiple output signals using only one sensor in electrical power supply systems with the following method steps:
∘ Conversion of a received analogue voltage signal of a Rogowski coil into a digital signal, hereinafter referred to as signal, wherein a frequency range with the lower frequency limit and the upper frequency limit is filtered from the signal, **characterised in that** the signal is scaled with an adjustable linear amplification factor,
∘ Integration of the signal by a Rogowski integrator, this Rogowski integrator being designed to perform the adaptation of the transmitted frequency range and amplification of the voltage signal, the output signal of the Rogowski integrator being proportional to the alternating current in a conductor surrounding the Rogowski coil, the integrated voltage signal being proportional to the alternating current to be measured,
∘ Duplication of the output signal into two identical signals,
∘ Scaling of the first output signal of the multiplication unit with a first amplification factor, wherein the first scaled output signal is proportional to the first output signal of the multiplication unit and the first proportionality factor changes proportionally with the change in the amplification factor,
∘ Scaling of the second output signal of the multiplication unit with a second amplification factor, wherein the second scaled output signal is proportional to the second output signal of the multiplication unit and the second proportionality factor changes proportionally with the change in the amplification factor,
∘ Conversion of the scaled first output signal into a proportional alternating current, whereby the alternating current is impressed into the output side up to a predeterminable first maximum power output,
∘ Conversion of the scaled second output signal into a proportional alternating current, whereby the alternating current is impressed into the output side up to a predeterminable second maximum power output,

9. Method according to claim 8, **characterised in that** the output signals are available as voltage signals,

10. Method according to claims 8, **characterised in that** the output signals are available as digital signals,

11. Method according to claim 10, wherein voltage signals from several Rogowski coils are supplied to different Rogowski integrators as measurement signals of different alternating currents, wherein the different output signals of the Rogowski integrators are output to the output unit configurably as their arithmetic or vectorial sum or as individual signals.

## Revendications

1. Système de détection de courant (1) pour mesurer des courants alternatifs avec des signaux de sortie multiples lors de l'utilisation d'un seul capteur dans des installations de l'alimentation en énergie électrique, présentant
∘ une bobine de Rogowski externe (2) qui délivre en sortie un signal de tension (Um) qui représente la tension d'induction par rapport au courant alternatif (I) qui circule dans un conducteur à travers la bobine de Rogowski de l'installation, le signal de tension (Um) représentant la dérivée proportionnelle et mathématiquement première du courant alternatif (I),
∘ une unité de conversion (3) qui est conçue pour convertir le signal de tension analogique (Um) en un signal numérique (Sr), désigné ci-après par signal,une plage de fréquences avec la limite de fréquence inférieure (Fu) et la limite de fréquence supérieure (Fo) étant filtrée à partir du signal (Sr), le signal étant mis à l'échelle avec un facteur d'amplification linéaire réglable (B),
∘ un intégrateur de Rogowski (4) adapté pour intégrer le signal (Sr), dont le signal de sortie (S) représente l'intégration de la tension (Um), le signal de sortie de l'intégrateur (Sr) étant proportionnel au courant alternatif (I),
∘ une unité de multiplication (5) qui est conçue pour multiplier le signal de sortie de l'intégrateur (S) en deux signaux identiques (S1) et (S2),
∘ une première unité de mise à l'échelle (6) adaptée pour multiplier le premier signal de sortie de l'unité de duplication (S1) par un facteur d'amplification (V1), le signal de sortie (SV1) étant proportionnel au premier signal de sortie de l'unité de duplication (S1) et, en outre, le facteur de proportionnalité variant proportionnellement avec la variation du facteur d'amplification (V1),
∘ une deuxième unité de mise à l'échelle (7) adaptée pour multiplier le deuxième signal de sortie de l'unité de duplication (S2) par un facteur d'amplification (V2), le signal de sortie (SV2) étant proportionnel au deuxième signal de sortie de l'unité de duplication (S2) et le facteur de proportionnalité variant proportionnellement avec la variation du facteur d'amplification (V2),
∘ une première unité de conversion (8) qui est conçue pour convertir le signal de sortie (SV1) de la première unité de mise à l'échelle en un courant alternatif proportionnel (I1), celle-ci étant conçue pour que le courant alternatif (I1) soit imprimé dans le côté de sortie jusqu'à une puissance maximale de sortie (PI1) pouvant être prédéfinie,
∘ une deuxième unité de conversion (9) qui est conçue pour convertir le signal de sortie (SV2) de la deuxième unité de mise à l'échelle en un courant alternatif proportionnel (12), celle-ci étant conçue pour que le courant alternatif (12) soit imprimé dans le côté de sortie jusqu'à une puissance maximale de sortie (PI2) pouvant être prédéfinie.

2. Système de détection de courant (12) selon la revendication 1, **caractérisé en ce que** la première unité de conversion (10) est conçue pour convertir le signal de sortie (SV1) de la première unité de mise à l'échelle en une tension alternative proportionnelle (U1) et **en ce que** cette tension alternative (U1) est appliquée au côté de sortie jusqu'à une puissance de sortie maximale (PU1) pouvant être prédéfinie, **caractérisé en ce que** la deuxième unité de conversion (11) est conçue pour convertir le signal de sortie (SV2) de la deuxième unité de mise à l'échelle en une tension alternative proportionnelle (U2) et **en ce que** la tension alternative (U2) est appliquée au côté sortie jusqu'à une sortie de puissance maximale (PU2) pouvant être prédéfinie,

3. Système de détection de courant (15) selon la revendication 1, dans lequel la première unité de conversion (13) est conçue pour mettre à disposition le signal de sortie (SV1) de la première unité de mise à l'échelle par le biais d'un protocole selon l'état de la technique (par exemple TCP, UDP) en tant que premier signal numérique (A1), dans lequel la deuxième unité de conversion (14) est conçue pour mettre à disposition le signal de sortie (SV2) de la deuxième unité de mise à l'échelle par le biais d'un protocole selon l'état de la technique (par exemple TCP, UDP) en tant que deuxième signal numérique (A2).

4. Système de détection de courant selon l'une des revendications précédentes, **caractérisé en ce que** les valeurs de la puissance maximale délivrée par les unités de mise à l'échelle, les facteurs de gain des unités de multiplication, les limites inférieure et supérieure de fréquence et les facteurs de gain linéaires des unités de conversion sont partiellement ou totalement fixes.

5. Système de détection de courant selon l'une des revendications précédentes, **caractérisé en ce que** l'unité de multiplication (4) présente au moins un autre signal de sortie qui représente le signal d'entrée d'une autre unité de mise à l'échelle, chaque autre unité de mise à l'échelle étant conçue, de mettre à l'échelle chaque autre signal de sortie de l'unité de multiplication avec respectivement un autre facteur d'amplification réglable et de l'amener ensuite respectivement à une autre unité de conversion, **caractérisé en ce que** chaque autre unité de conversion traite les grandeurs d'entrée avec d'autres sorties de puissance maximales réglables des courants de sortie respectifs ou des tensions de sortie et les met à disposition en tant qu'autre signal de sortie.

6. Matrice de détection de courant (33) composée de trois systèmes de détection de courant selon l'une des revendications précédentes, dans laquelle un premier courant alternatif (IA) est mesuré en appliquant la tension de sortie (UAm) de la première bobine de Rogowski (23) à la première unité de conversion avec le premier facteur d'amplification (BA) et au premier intégrateur de Rogowski (25) et dont la première grandeur de sortie (SA) est appliquée à une matrice de multiplication (29) comme grandeur d'entrée, le deuxième courant alternatif IB étant mesuré, en amenant la tension de sortie (UBm) de la deuxième bobine de Rogowski (20) de la deuxième unité de conversion et son signal de sortie au deuxième intégrateur de Rogowski (21) et en l'amenant comme grandeur de sortie (SB) à la matrice de duplication (29) comme grandeur d'entrée, **caractérisé en ce que** le troisième courant alternatif IC est mesuré, en appliquant la tension de sortie (UCm) de la troisième bobine de Rogowski (26) de la troisième unité de conversion (27) et son signal de sortie au troisième intégrateur de Rogowski (28) et en l'appliquant comme grandeur de sortie (SC) à la matrice de duplication (29) comme grandeur d'entrée, **caractérisé en ce que** la matrice de duplication applique l'une des entrées (SA), (SB), (SC) à l'une de ses nombreuses sorties quelconques (S 1, S2,.. SN), (nombre N), **en ce que** la matrice de duplication présente un signal de configuration (F1, F2, ... FN) pour chaque sortie, qui détermine laquelle des entrées est délivrée sur quelle sortie, **en ce que** le signal de configuration (F1, F2, ... FN) détermine le nombre de sorties à utiliser.... FN) détermine en outre qu'en alternative la matrice de multiplication détermine la somme arithmétique des signaux de sortie des trois intégrateurs de Rogowski (SA), (SB), (SC), et la transmet à une ou plusieurs des N sorties (S1, S2,.. SN), **caractérisé en ce que** les sorties (S1, S2, ... SN) de la matrice de multiplication sont transmises à autant d'unités de sortie (30, 31, 32), chaque unité de sortie se composant d'une unité de mise à l'échelle et d'une unité de conversion de l'une des revendications précédentes et formant le signal de sortie (X1, X2, ... XN).

7. Matrice de détection de courant selon la revendication 6, composée d'un nombre quelconque de systèmes de détection de courant, la matrice de multiplication additionnant arithmétiquement ou vectoriellement d'autres trajets de courant par des calculs et les délivrant à l'une des unités de sortie, **caractérisée en ce que** la matrice de multiplication traite des courants de systèmes multiphases ou de sous-réseaux quelconques.

8. Procédé de mesure de courants avec des signaux de sortie multiples lors de l'utilisation d'un seul capteur dans des installations d'alimentation en énergie électrique, comprenant les étapes de procédé suivantes :
∘ Conversion d'un signal de tension analogique reçu d'une bobine de Rogowski en un signal numérique, désigné ci-après par signal, une plage de fréquences avec la limite de fréquence inférieure et la limite de fréquence supérieure étant filtrée à partir du signal, **caractérisée en ce que** le signal est mis à l'échelle avec un facteur d'amplification linéaire réglable,
∘ l'intégration du signal par un intégrateur de Rogowski, cet intégrateur de Rogowski étant conçu pour effectuer l'adaptation de la gamme de fréquences transmises et l'amplification du signal de tension, le signal de sortie de l'intégrateur de Rogowski étant proportionnel au courant alternatif dans un conducteur entourant la bobine de Rogowski, le signal de tension intégré étant proportionnel au courant alternatif à mesurer,
∘ Multiplication du signal de sortie en deux signaux identiques,
∘ la mise à l'échelle du premier signal de sortie de l'unité de duplication avec un premier facteur d'amplification, le premier signal de sortie mis à l'échelle étant proportionnel au premier signal de sortie de l'unité de duplication et le premier facteur de proportionnalité variant proportionnellement avec la variation du facteur d'amplification,
∘ la mise à l'échelle du deuxième signal de sortie de l'unité de duplication avec un deuxième facteur d'amplification, le deuxième signal de sortie mis à l'échelle étant proportionnel au deuxième signal de sortie de l'unité de duplication et le deuxième facteur de proportionnalité variant proportionnellement avec la variation du facteur d'amplification,
∘ conversion du premier signal de sortie mis à l'échelle en un courant alternatif proportionnel, le courant alternatif étant appliqué au côté de sortie jusqu'à une première puissance de sortie maximale pouvant être prédéfinie,
∘ conversion du deuxième signal de sortie mis à l'échelle en un courant alternatif proportionnel, le courant alternatif étant imprimé dans le côté de sortie jusqu'à une deuxième puissance de sortie maximale pouvant être prédéfinie,

9. Procédé selon la revendication 8, **caractérisé en ce que** les signaux de sortie sont disponibles sous forme de signaux de tension,

10. Procédé selon les revendications 8, **caractérisé en ce que** les signaux de sortie sont disponibles sous forme de signaux numériques,

11. Procédé selon la revendication 10, dans lequel des signaux de tension de plusieurs bobines de Rogowski sont amenés à différents intégrateurs de Rogowski en tant que signal de mesure de différents courants alternatifs, les différents signaux de sortie des intégrateurs de Rogowski étant délivrés à l'unité de sortie de manière configurable en tant que leur somme arithmétique ou vectorielle ou en tant que signaux individuels.
